# EUROPEAN PATENT APPLICATION

(11) **EP 3 975 184 A1**
(43) Date of publication of application: **30.03.2022**
(21) Application number: 20315418.2
(22) Date of filing: 23.09.2020
(51) Int. Cl.: G11C 11/16

(54) **MAGNETIC RANDOM ACCESS MEMORY CELL COMPRISING A FERRIMAGNETIC FREE LAYER**

(71) Applicant: Antaios, 38240 Meylan (FR)
(72) Inventor: Drouard, Marc, 26000 Valence (FR); Martin, Sylvain, 38100 Grenoble (FR); Kula, Witold, Gilroy, CA 95020 (US)
(74) Representative: P&TS SA (AG, Ltd.)

(57) **Abstract**

The present disclosure concerns a magnetic random access memory (MRAM) cell (100), comprising a first magnetic tunnel junction (MTJ) element (10) comprising a tunnel barrier layer (22) between a reference layer (21) having a reference magnetization (210) and a free layer (23) having a free magnetization (230) that can be freely oriented, the reference and free layers (21, 23) having a perpendicular magnetic anisotropy (PMA) The MRAM) cell (100)is configured to pass a write current (31) substantially parallel to the plane of the free layer (23) and adapted for switching a second magnetization (230) by a spin current by SOT interaction. The free layer (23) comprises a ferrimagnetic material. The MRAM cell (100) further comprises a polarizing layer (25) configured to magnetically couple the free layer (23) such that the free magnetization (230) comprises an in-plane component that is substantially parallel to the write current (31).

## Description

### Technical domain

The present disclosure relates to a magnetic memory element and more particularly a magnetic memory element that is deterministically switchable by a writing current using a spin orbit torque (SOT) interaction.

### Related art

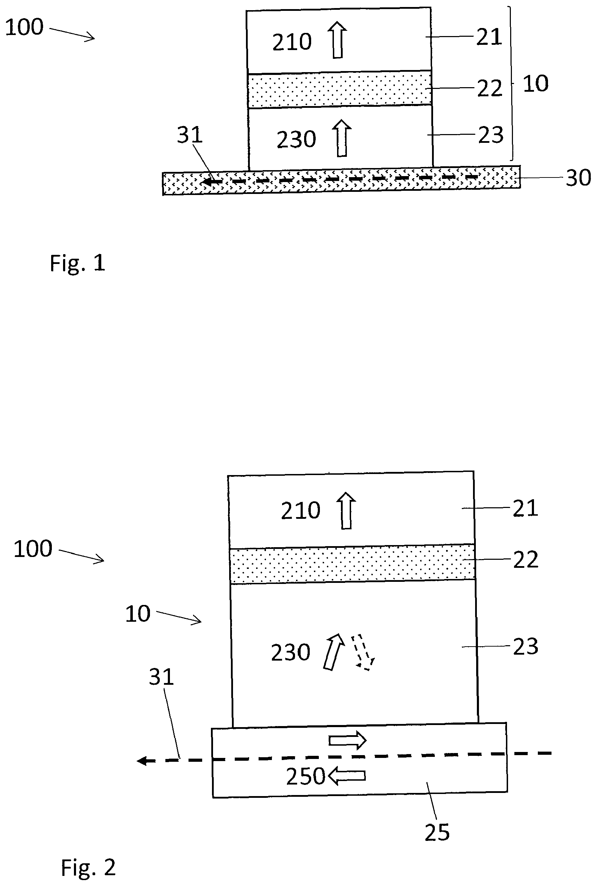

Fig. 1 shows a MRAM cell 100 comprising a magnetic tunnel junction (MTJ) element 10 including a tunnel barrier layer 22 sandwiched between a reference layer 21 having a reference magnetization 210 and a free layer 23 having a free magnetization 230. The reference layer 21 and the free layer 23 exhibit a perpendicular magnetic anisotropy (PMA). In other words, each of the reference layer 21 and the free layer 23 exhibits a preferential axis of its respective magnetizations 210, 230 that is perpendicular to the plane of the layer (out-of-plane). In some embodiments, an anti-parallel alignment of the free magnetization 230 with respect to the reference magnetization 210 corresponds to a first data value (e.g., a "0" value) and a parallel alignment of the free magnetization 230 with respect to the reference magnetization 210 corresponds to a second data value different from the first data value (e.g., a "1" value)..

The MRAM cell 100 is further configured to pass a write current 31 adapted for switching the free magnetization 230 by a spin current by spin orbit torque (SOT) interaction. The write current exerts a torque on the free magnetization, through for example spin Hall effect and/or Rashba-Edelstein effect, so that the orientation of the free magnetization change, for example, from being parallel to antiparallel to the pinned magnetization. Writing an MRAM cell by using a SOT interaction allows to eliminate the need to pass the write current through the MTJ. The SOT based writing further allows to use separate read and write-paths which is beneficial for a long life of the MRAM cell.

The SOT based writing allows for using separate read- and write-paths which is beneficial for a long life of the MRAM cell 100. In the case the reference and free magnetizations 210, 230 are out-of-plane, a magnetic field having at least a component parallel to the write current must be applied in addition to the write current in order to deterministically switch the free magnetization 230. However, the need for an external applied field significantly hinders the technological viability of commercial applications.

### Summary

The present disclosure concerns a MRAM cell, comprising a first magnetic tunnel junction (MTJ) element comprising a tunnel barrier layer between a reference layer having a reference magnetization and a free layer having a free magnetization that can be freely oriented, the reference and free layers having a PMA. The MRAM cell is configured to pass a write current substantially parallel to the plane of the free layer and adapted for switching a second magnetization by a spin current by SOT interaction. The free layer comprises a ferrimagnetic material. The MRAM cell further comprises a polarizing layer configured to magnetically couple the free layer such that the free magnetization comprises an in-plane component that is substantially parallel to the write current.

In the MRAM cell disclosed herein, the magnetic coupling of the ferrimagnetic free layer by the polarizing layer allows for breaking the symmetry by providing an in-plane component of the free magnetization.

### Short description of the drawings

Exemplar embodiments of the invention are disclosed in the description and illustrated by the drawings in which:
Fig. 1 shows a MRAM cell comprising a tunnel barrier layer, a reference layer having a reference magnetization, a free layer having a free magnetization and a current layer;
Fig. 2 represents a MRAM cell comprises a polarizing layer configured to magnetically couple the free layer, according to an embodiment;
Fig. 3 represents the MRAM cell of Fig. 2 showing details of the orientation of the free magnetization in the free layer;
Fig. 4 shows a partial view of the MRAM cell wherein at least a portion of the free layer is configured to pass a write current, according to an embodiment;
Fig. 5 represents a partial view of the MRAM cell comprising a non-magnetic spacer layer, according to an embodiment;
Fig. 6 shows a partial view of the MRAM cell wherein the free layer comprises a synthetic ferrimagnet including sub-layers, according to an embodiment;
Fig. 7 represents the free layer comprising the sub-layers and the free magnetization, according to an embodiment;
Fig. 8 shows a partial view of the MRAM cell wherein the current layer comprises the polarizing layer, according to an embodiment;
Fig. 9 shows a partial view of the MRAM cell wherein the polarizing layer comprises a synthetic antiferromagnet, according to an embodiment;
Fig. 10 shows a partial view of the MRAM cell further comprising an enhancing free layer having a enhancing free magnetization, according to an embodiment; and
Fig. 11 shows the MRAM cell comprising the enhancing free layer, according to an embodiment.

### Examples of embodiments

Fig. 2 represents a MRAM cell 100 comprising a MTJ element 10 including a tunnel barrier layer 22 sandwiched between a free layer 23 having a free magnetization 230 and a ferromagnetic reference layer 21 having a reference magnetization 210, such that the MRAM cell 100 forms a magnetic tunnel junction. The reference and free layers 21, 23 exhibit a perpendicular magnetic anisotropy (PMA) such that the reference and free magnetizations 210, 230 are perpendicular to the plane of the layer (out-of-plane). The MRAM cell 100 is further configured to pass a write current 31 substantially parallel to the plane of the free layer 23.

According to an embodiment, the free layer 23 comprises a ferrimagnetic material. The MRAM cell 100 further comprises a polarizing layer 25 having a polarizing magnetization 250 and configured to magnetically couple the ferrimagnetic material of the free layer 23 such as to orient the free magnetization 230 at least partially in the plane of the free layer 23 (in-plane). In other words, the free magnetization 230 comprises a component that is substantially parallel to the write current 31 (called in-plane component hereafter). The in-plane component of the free magnetization 230 allows to deterministically switch the free magnetization 230 when the write current 31 is passed, without using an external magnetic field. As shown in the example of Fig. 2, the free magnetization 230 can be switched between an orientation substantially parallel (plain line arrow) to the reference magnetization 210 and an orientation substantially antiparallel (dotted line arrow) to the reference magnetization 210.

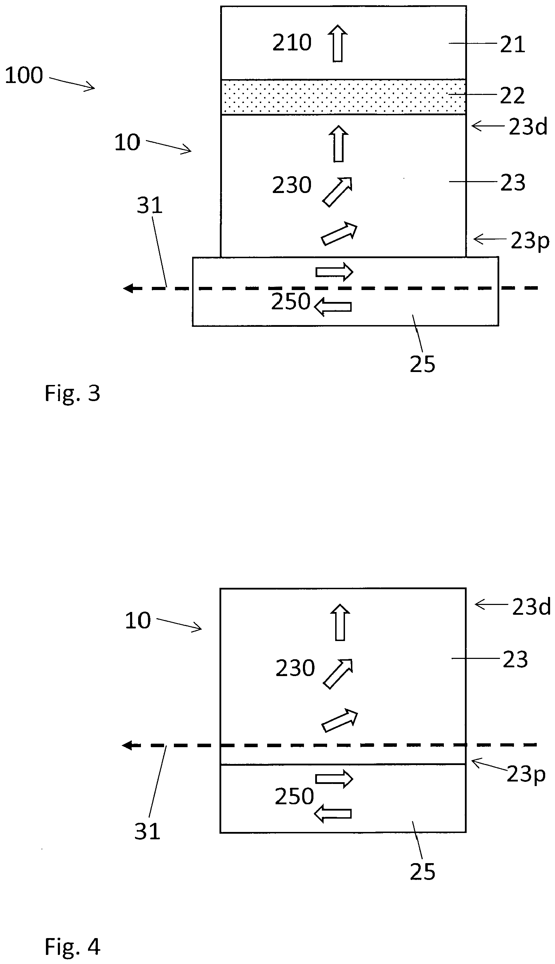

Referring to **Fig. 3****,** the polarizing layer 25 magnetically couples the ferrimagnetic material of the free magnetization 230 in an orientation substantially in-plane in a proximal portion 23p of the free layer that is proximal to the polarizing layer 25 (or nearest to the polarizing layer 25). The free magnetization 230 in a distal portion 23d of the free layer that is distal from the polarizing layer 25 (or farthest to the polarizing layer 25) is far less affected by the coupling of the polarizing layer 25 and is oriented substantially out-of-plane. Thus, the magnetic coupling of the polarizing layer 25 can cause the orientation of the free magnetization 230 to gradually vary from a substantially in-plane direction in the proximal portion 23p of the free layer 23 and a substantially out-of-plane direction in the distal portion 23d of the free layer 23. The varying orientation of the free magnetization 230 between the distal and proximal portions 23p, 23d of the free layer 23 results in a net free magnetization 230 having a mainly out-of-plane orientation comprising an in-plane component.

In some aspects, the reference magnetization 210 can be substantially fixed (e.g., either in the up or down direction) and the free magnetization 230 can be freely oriented. The reference layer 21 can comprise a pinned ferromagnetic layer having a pinned magnetization, for example pinned by an antiferromagnetic layer.

In some aspects, the ferrimagnetic material of the free layer 23 can comprise any one of a MnCoSb, MnGa based material, GdCo, Colr or CoTb. The free layer 23 may have a thickness between 0.5 nm and 10 nm or between 3 nm and 5 nm.

The tunnel barrier layer 22 can include a material, such as MgO or Al₂O₃.

In the particular embodiment of Figs. 2 and 3, the polarizing layer 25 is configured to pass the write current 31. In such configuration, the polarizing layer 25 is configured to generate a spin current when the write current 31 is passed. The spin current exerting a torque adapted to switch the free magnetization 230, for example, from being parallel to antiparallel to the reference magnetization 210. In Figs. 2 and 3 the polarizing layer 25 is represented larger than the free layer 23 although both layers could have substantially the same width.

The polarizing layer 25 can comprise an antiferromagnetic material as illustrated in Figs. 2 and 3. The antiferromagnetic material can comprise NiOx, MnO, MnS, MnTe, MnF2, FeO, CoO, FeMn, PtMn, IrMn or any other suitable antiferromagnetic material.

In one aspect, the polarizing layer 25 comprises a ferromagnetic material configured to generate a spin current when the write current 31 is passed. Such material can comprise, but is not limited to, any one of: PtCo, CoCrPt, FeW, CoNi, CoPd, CoFeB, CoFe, Co, NiFe, Fe or Ni.

In another embodiment illustrated in **Fig. 4****,** the free layer 23, or the at least a portion of the free layer 23 is configured to pass the write current 31. In this configuration, the at least a portion of the free layer 23 is configured to pass the write current 31 and generate a spin current when the write current 31 is passed. The spin current exerts a torque adapted to switch the free magnetization 230, for example, from being parallel to antiparallel to the reference magnetization 210. In one aspect, the portion of the free layer 23 configured to pass the write current 31 corresponds to the proximal portion 23p.

The MRAM cell 100 can comprise an electrically conductive connector (not shown) configured to supply the write current 31 to the portion of the free layer 23 or the polarizing layer 25.

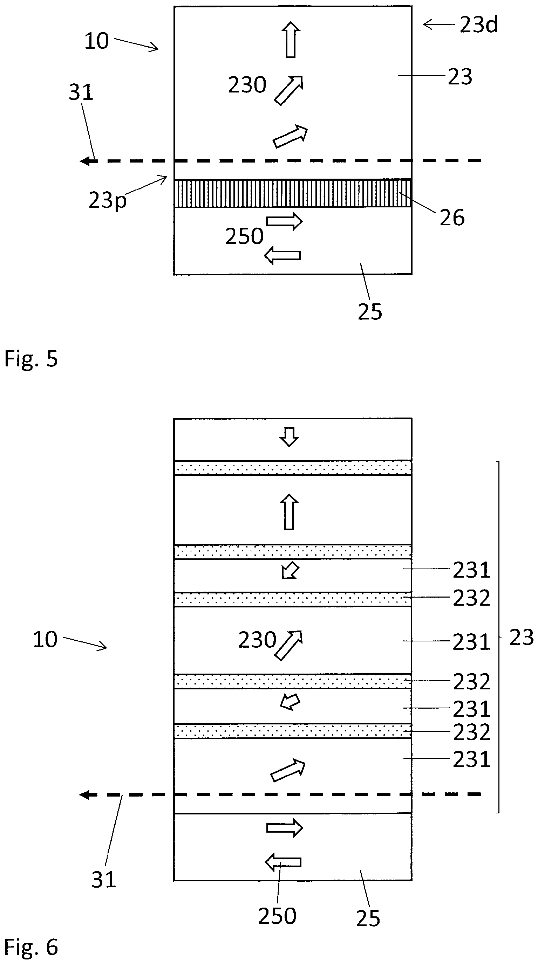

As illustrated in Figs. 2 and 3, the polarizing layer 25 can be in physical contact with the free layer 23. However, as shown in **Fig. 5****,** a non-magnetic spacer layer 26 can be comprised between the polarizing layer 25 and the free layer 23. The spacer layer 26 magnetically couples the polarizing layer 25 and the free layer 23. Providing the spacer layer 26 is not limited to the configuration of Fig. 4 and the spacer layer 26 can be added between the polarizing layer 25 and the free layer 23 in the MRAM cell configuration of Figs. 2 and 3. The spacer layer 26 can comprise an oxide, for example and without being limited to, any one of MgO, AlOx, HfOx, TiOx or a metal, for example and without being limited to, any one of Ru, Ir, W, Ta or Pt. The spacer layer 26 can improve the magnetic coupling between the polarizing layer 25 and the free magnetic layer 23. The spacer layer 26 can further be used for improving growth of the free magnetic layer 23 over the spacer layer 26. The spacer layer 26 can further be used for providing electrical insulation between the free magnetic layer 23 and the polarizing layer 25. The spacer layer 26 should be thin enough to allow some magnetic coupling between the free magnetic layer 23 from the polarizing layer 25.

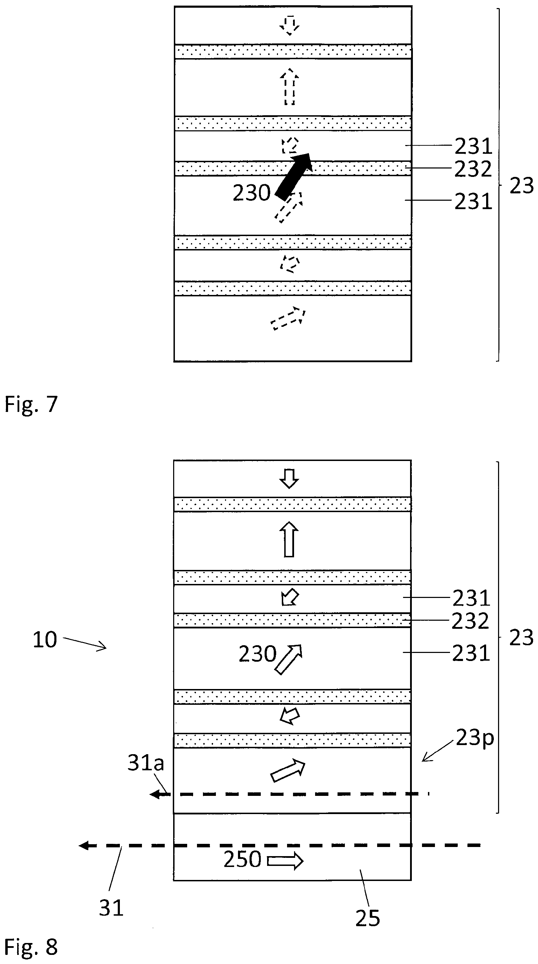

In yet another embodiment illustrated in **Fig. 6****,** the free layer 23 comprises a synthetic ferrimagnet (SyF) including at least a tri-layer including two ferromagnetic sub-layers 231 separated by a coupling sub-layer 232 and antiferromagnetic exchange coupled across the coupling sub-layer 232. The coupling sub-layer 232 can comprise a metal such as Ir, Ru, Mo or Tb. As illustrated in Fig. 6, the free layer 23 comprises a plurality of bi-layers, each bi-layer comprising a ferromagnetic sub-layer 231 and a coupling sub-layer 232. Each ferromagnetic sub-layer 231 is antiferromagnetic exchange coupled across the coupling sub-layer 232 between two adjacent ferromagnetic sub-layers 231, thus having opposite orientation of the free magnetization 230. The SyF is configured such that magnitude of the free magnetization 230 differs in the ferromagnetic sub-layers 231 on each side of the coupling sub-layer 232free. The different magnitude of the free magnetization 230 can be obtain by having different thicknesses for the ferromagnetic sub-layers 231 on each side of the coupling sub-layer 232. The different magnitude of the free magnetization 230 results in a non-null net free magnetization 230 in the free layer 23. **Fig. 7** represents the free layer 23 comprising the sub-layers 231, 232 wherein the free magnetization 230 for each ferromagnetic sub-layer 231 is represented by the dotted line arrows and the net free magnetization 230 is represented by the plain line arrow. The ferromagnetic sub-layer 231 and the coupling sub-layer 232 can have a thickness between 0.1 nm and 2 nm.

In one aspect, the materials of the ferromagnetic sub-layers 231 and/or the coupling sub-layer 232 can generate a spin current. For example, the ferromagnetic sub-layer 231 can comprise Co and the coupling sub-layer 232 can comprise Ir, Tb, Ru, Mo or any other suited materials. As illustrated in the example of Fig. 6, at least a portion of the free layer 23 can be used to pass the write current 31.

**Fig. 8** shows an alternative embodiment of the MRAM cell 100 of Fig. 6, where the polarizing layer 25 is adapted to pass the write current 31 and generate a spin current when the write current 31 is passed. For instance, the polarizing layer 25 can comprise a single layer comprising a ferromagnetic material (as illustrated in Fig. 8). In some aspects, both the free magnetic layer 23 and the polarizing layer 25 may be configured to generate a spin current when the write current 31 is passed. Fig. 8 shows a portion of the write current 31 (indicated by the numeral "31a") passing in the proximal portion 23p of the free layer 23.

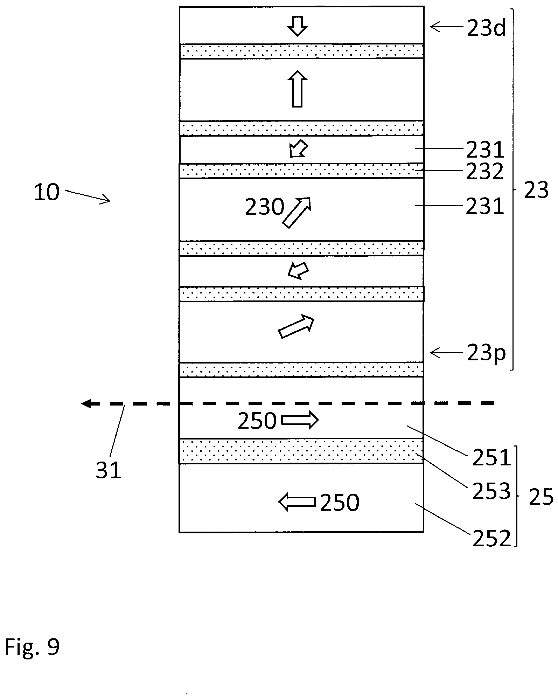

**Fig. 9** shows another alternative embodiment of the MRAM cell 100, wherein the polarizing layer 25 comprises a synthetic antiferromagnet (SAF) layer including a non-magnetic layer 253 sandwiched between a first polarizing ferromagnet layer 251 and a second polarizing ferromagnet layer 252. The first and second polarizing ferromagnet layer 251, 252 can comprise a ferromagnetic material including, but is not limited to, any one of: PtCo, CoCrPt, FeW, CoNi, CoPd, CoFeB, CoFe, Co, NiFe, Fe or Ni. The non-magnetic layer 253 can comprise any one of: W, Ta, Ru.

One of the first or second polarizing ferromagnet layer 251, 252 or the non-magnetic layer 253 or any combination of the layers 251, 252, 253 can be used for passing the write current 31. As discussed above, the free magnetic layer 23 and the polarizing layer 25 can be configured such that both the write current 31 flowing in the polarizing layer 25 and the portion 31a of the write current 31 flowing in the free layer 23 generate a spin current.

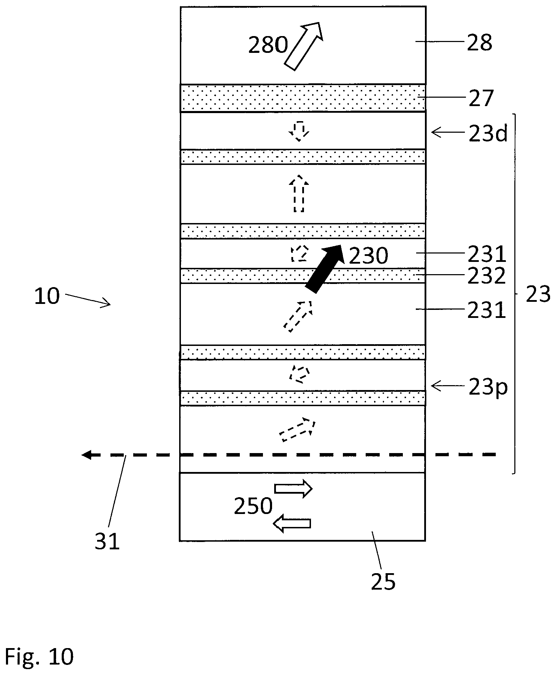

In an embodiment shown in **Fig. 10****,** the MRAM cell 100 having the configuration illustrated in Fig. 8 further comprises an enhancing free layer 28 having an enhancing free magnetization 280 and separated from the free layer 23 by an enhancing spacer layer 27. The enhancing spacer and free layers 27, 28 are at the distal end of the free layer 23. The enhancing spacer layer 27 can comprise a non-magnetic material such as Ir, Mo, Pt, Ru, W, Ta or MgO. The enhancing free layer 28 can comprise a ferromagnetic material, for example comprising Co, Fe, CoFe or CoFeB. The enhancing spacer and free layers 27, 28 allow for enhancing the tunnel magnetoresistance of the MRAM cell 100.

In Fig. 10, the free magnetization 230 for each sub-layer 231, 232 is represented by the dotted line arrows and the net free magnetization 230 is represented by the plain line arrow. Due to the coupling of the polarizing layer 25, the net free magnetization 230 comprises an in-plane component. The ferromagnetic coupling between the enhancing free layer 28 and the free layer 23 via the enhancing spacer layer 27 ensures that the enhancing free magnetization 280 is oriented substantially parallel to the net free magnetization 230 (and thus also comprises an in-plane component).

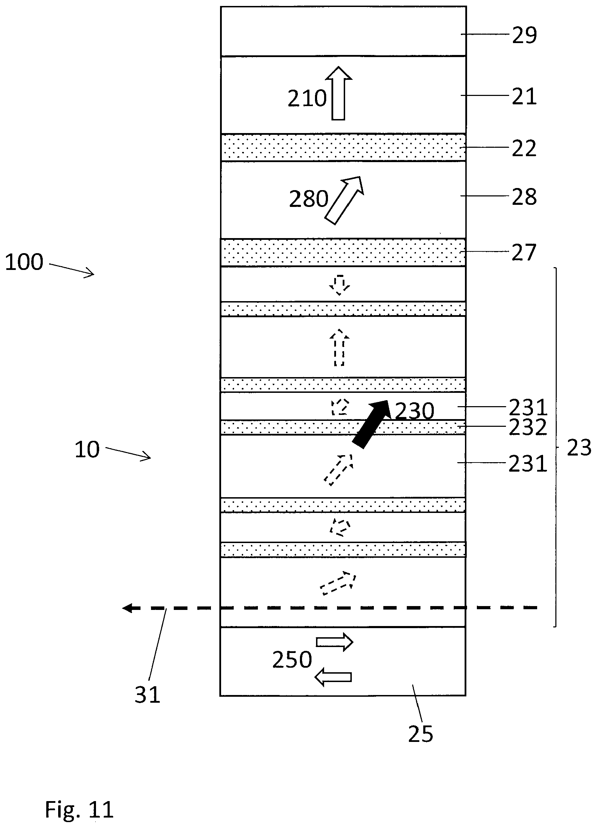

**Fig. 11** shows the MRAM cell 100 according to the configuration illustrated in Fig. 10 further comprising a tunnel barrier layer 22 sandwiched between the enhancing free layer 28 and a ferromagnetic reference layer 21 having a reference magnetization 210, such that the MRAM cell 100 forms a magnetic tunnel junction. In Fig. 11, the free magnetization 230 for each sub-layer 231, 232 is represented by the dotted line arrows and the net free magnetization 230 is represented by the plain line arrow. The reference magnetization 210 exhibit a PMA and is thus oriented substantially out-of-plane (perpendicular to the plane of the reference layer 21). Both the net free magnetization 230 and the enhancing free magnetization 280 are oriented substantially out-of-plane and comprising an in-plane component. The net free magnetization 230 and the enhancing free magnetization 280 can be switched parallel or antiparallel to the reference magnetization 210 when the write current 31 is passed in the MRAM cell 100. The in-plane component of the net free magnetization 230 and the enhancing free magnetization 280 allows for deterministically switching the magnetizations 280. A capping layer 29, such as an electrically conductive layer, can contact the reference layer 21 on its side opposed to the one contacting the tunnel barrier layer 22.

In the examples above, the position of the free layer 23 and reference layer 21 relative to the tunnel barrier layer 22 can be reversed. The polarizing layer 25 should be adjacent to the free layer, possibly separated by the spacer layer 26.

### Reference numbers and symbols

- 10: MTJ element
- 100: MRAM cell
- 21: reference layer
- 210: reference magnetization
- 22: tunnel barrier layer
- 23: free layer
- 23p: proximal portion of the free layer
- 23d: distal portion of the free layer
- 230: free magnetization
- 231: ferromagnetic sub-layer
- 232: coupling sub-layer
- 25: polarizing layer
- 250: polarizing magnetization
- 251: first polarizing ferromagnet layer
- 252: second polarizing ferromagnet layer
- 253: non-magnetic layer
- 26: spacer layer
- 27: enhancing spacer layer
- 28: enhancing free layer
- 280: enhancing free magnetization
- 29: capping layer
- 31: write current
- 31a: portion of the write current
- 32: connector

## Claims

1. A magnetic random access memory (MRAM) cell (100), comprising:
a first magnetic tunnel junction (MTJ) element (10) comprising a tunnel barrier layer (22) between a reference layer (21) having a reference magnetization (210) and a free layer (23) having a free magnetization (230) that can be freely oriented, the reference and free layers (21, 23) having a perpendicular magnetic anisotropy (PMA);
the MRAM cell (100) being configured to pass a write current (31) substantially parallel to the plane of the free layer (23) and adapted for switching a second magnetization (230) by a spin current by SOT interaction;
**characterized in that**
the free layer (23) comprises a ferrimagnetic material; and
the MRAM cell (100) further comprises a polarizing layer (25) configured to magnetically couple the free layer (23) such that the free magnetization (230) comprises an in-plane component that is substantially parallel to the write current (31).

2. The MRAM cell according to claim 1,
wherein the free magnetization (230) is in an orientation substantially in the plane of the free layer (23) in a proximal portion (23p) of the free layer (23) nearest the polarizing layer (25); and
wherein the free magnetization (230) is in an orientation substantially perpendicular to the plane of the free layer (23) in a distal portion (23d) of the free layer (23) farthest the polarizing layer (25).

3. The MRAM cell according to claim 1 or 2,
wherein the polarizing layer (25) is configured to pass the write current (31) and to generate a spin current when the write current (31) is passed.

4. The MRAM cell according to any one of claims 1 to 3,
wherein the free magnetic layer (23) comprises MnCoSb, MnGa based material or GdCo.

5. The MRAM cell according to any one of claims 1 to 4,
wherein the polarizing layer (25) comprises an antiferromagnetic material, notably NiOx, MnO, MnS, MnTe, MnF2, FeO, CoO, FeMn, PtMn, IrMn.

6. The MRAM cell according to any one of claims 1 to 4,
wherein the polarizing layer (25) comprises a ferromagnetic material.

7. The MRAM cell according to claim 6,
wherein the ferromagnetic material comprises any one of: PtCo, CoCrPt, FeW, CoNi, CoPd, CoFeB, CoFe, Co, NiFe, Fe or Ni.

8. The MRAM cell according to any one of claims 1 to 3,
wherein at least a portion of the free layer (23) is configured to pass the write current (31) and to generate a spin current when the write current (31) is passed.

9. The MRAM cell according to any one of claims 1 to 8,
wherein the polarizing layer (25) is in physical contact with the free layer (23).

10. The MRAM cell according to any one of claims 1 to 8,
wherein the polarizing layer (25) is separated from the free magnetic layer (23) by non-magnetic spacer layer (26) magnetically coupling the polarizing layer (25) and the free layer (23).

11. The MRAM cell according to any one of claims 1 to 10,
wherein the free layer (23) comprises a synthetic ferrimagnet including at least a tri-layer including two ferromagnetic sub-layers (231) separated by a coupling sub-layer (232) or a plurality of bi-layers, each bi-layer comprising a ferromagnetic sub-layer (231) and a coupling sub-layer (232), two adjacent ferromagnetic sub-layers (231) being antiferromagnetically exchange coupled across the coupling sub-layer (232); and
wherein the magnitude of the free magnetization (230) differs in two adjacent ferromagnetic sub-layers (231) across the coupling sub-layer (232).

12. The MRAM cell according to claim 11,
wherein the first and second ferromagnetic sub-layers (231, 232) comprises Co and the non-magnetic sub-layer (233) comprises Ir, Ru, Mo or Tb alloy or any compound comprising these elements.

13. The MRAM cell according to any one of claims 1 to 12
wherein the polarizing layer (25) comprises a synthetic antiferromagnet (SAF) layer including a non-magnetic layer (253) sandwiched between a first polarizing ferromagnet layer (251) and a second polarizing ferromagnet layer (252).

14. The MRAM cell according to any one of claims 1 to 12 further comprising a enhancing free layer (28) having a enhancing free magnetization (280) and separated from the free layer (23) by a non-magnetic enhancing spacer layer (27); and
wherein the enhancing free magnetization (280) is oriented substantially parallel to the net free magnetization (230).

15. The MRAM cell according to claim 14,
wherein the enhancing free layer (28) comprises a ferromagnetic material.
